Europäisches Patentamt

European Patent Office

Office européen des brevets

(11) Veröffentlichungsnummer: **0 144 887**
**A2**

## (12) EUROPÄISCHE PATENTANMELDUNG

(21) Anmeldenummer: **84114273.0**

(22) Anmeldetag: **26.11.84**

(51) Int. Cl.⁴: **H 01 L 23/48**

(30) Priorität: **30.11.83 DE 3343351**

(43) Veröffentlichungstag der Anmeldung:
**19.06.85 Patentblatt 85/25**

(84) Benannte Vertragsstaaten:
**AT DE FR GB IT**

(71) Anmelder: **Siemens Aktiengesellschaft
Berlin und München Wittelsbacherplatz 2
D-8000 München 2(DE)**

(72) Erfinder: **Pammer, Erich, Dr. rer. nat.
Platanenstrasse 59
D-8028 Taufkirchen(DE)**

(54) **Halbleiterbauelement mit höckerartigen, metallischen Anschlusskontakten und Mehrlagenverdrahtung.**

(57) Halbleiterbauelement mit höckerartigen, metallischen Anschlußkontakten und Mehrlagenverdrahtung, bei dem die einzelnen Leitbahnen eines jeden in Mehrlagenverdrahtungstechnik zu verdrahtenden elektrischen Signales bzw. Potentiales im Bereich des jeweiligen Anschlußkontaktes elektrisch mit diesem und untereinander verbunden sind, in den restlichen Bereichen des Halbleiterbauelementes jedoch durch Isolierschichten voneinander getrennt sind. Die verschiedenen Isolierschichten enden jeweils außerhalb einer gedachten, senkrechten Projektionslinie des Randes der Grundfläche des zugehörigen Anschlußkontaktes in einer Entfernung von mindestens 5 μm, wobei besagte Grundfläche definiert ist als horizontale Schnittfläche durch den betreffenden Anschlußkontakt in der Höhe, in der dieser die größte horizontale Ausdehnung auf einer darunterliegenden Endpassivierungsschicht besitzt. Damit werden beim Kontaktiervorgang in den unter den Anschlußkontakten liegenden Schichten Risse und Brüche sicher vermieden.

FIG 4

EP 0 144 887 A2

Siemens Aktiengesellschaft
Berlin und München

Unser Zeichen
VPA 83 P 1 9 1 5 E

Halbleiterbauelement mit höckerartigen, metallischen Anschlußkontakten und Mehrlagenverdrahtung

Die Erfindung betrifft ein Halbleiterbauelement mit höckerartigen, metallischen Anschlußkontakten und Mehrlagenverdrahtung nach dem Oberbegriff des Patentanspruchs 1.

Elektronische Halbleiterleiterschaltkreise müssen bekanntermaßen im Anwendungsfall mit den sonstigen Teilen einer elektrischen Schaltung verbunden werden, was z. B. durch Löt-  oder Drahtverbindungen geschieht. Dabei wird jedoch wegen der Gefahr der Beschädigung im allgemeinen diese Verbindung nicht direkt am Halbleiterbauelement (Chip) eines solchen Halbleiterschaltkreises hergestellt, sondern an einem "Verbindungsstück". Solch ein Verbindungsstück ist beispielsweise ein Kontaktfleck auf dem Träger einer sogenannten Micropack-Konstruktion. Diese Ausführung ist in der Halbleiterindustrie wohl bekannt. Sie vermeidet einen sonst notwendigen direkten mechanischen Zugriff des Bauelementkunden auf das Halbleiterbauelement des Halbleiterschaltkreises. Das dabei noch notwendige Verbinden  des erwähnten Kontaktfleckes mit einem entsprechenden Anschlußkontakt auf dem Halbleiterbauelement selbst erfolgt noch durch dessen Hersteller, gleichzeitig in einem Arbeitsgang für alle Kontaktanschlüsse des Bauelementes. Diesen Vorgang nennt man Automatic Tape Bonding. Die Kontaktanschlüsse des Halbleiterbauelementes sind dabei als metallische Höcker

Ke 1 Hub / 07.11.1983

ausgeführt, bestehen ggf. aus mehreren Materialien, von denen zumindest die oberste Schicht gut lötfähig oder thermokomprimierbar ist, und sind entweder aus Gold oder mit einer Goldschicht überzogen (Kontaktierung erfolgt über Thermokompression) oder bestehen mindestens an ihrer Oberfläche aus einem lötfähigen Material, wie Gold, Silber oder Kupfer, überzogen mit Zinn oder einer Blei-Zinn-Legierung. Sie können sich sowohl am Rande des Halbleiterbauelementes, dem sogenannten inaktiven Bereich, befinden oder aber auch in dessen aktivem Bereich.

Die zunehmende Komplexität und die steigende Integrationsdichte integrierter Halbleiterbauelemente hat dazu geführt, daß die Signal- und Potentialführung innerhalb dieser Bauelemente heute oft in der sogenannten Mehrlagentechnik erfolgt im Gegensatz zur früheren Einlagentechnik. Dabei werden die verwendeten elektrische Signale und Potentiale nicht mehr nur in einer Ebene geführt, sondern in mehreren, jeweils getrennt durch elektrisch isolierende Schichten, wie z. B. Siliziumdioxid, Siliziumnitrid, verschiedene Polyimide. Die Verbindung einzelner Lagen gleicher Signale bzw. Potentiale wird dabei in erster Linie im Bereich des jeweiligen Anschlußkontaktes durchgeführt.

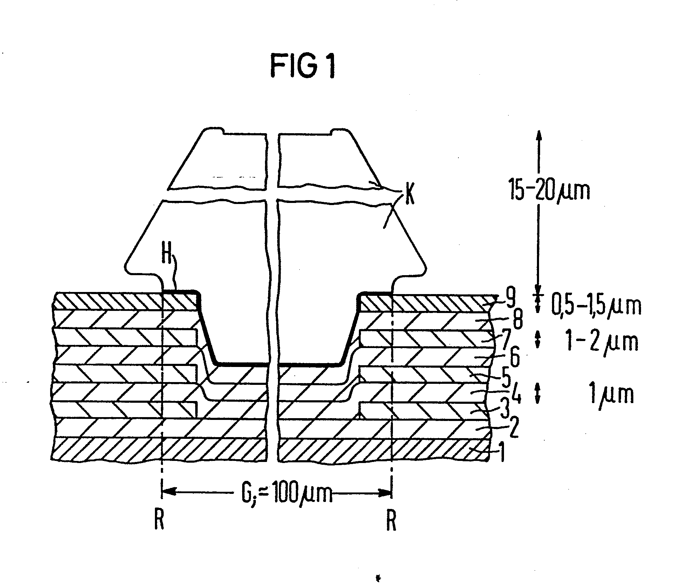

Bei bisher.üblichen Halbleitertechnologien kommen dann, wie in Fig. 1 dargestellt, unter eine Grundfläche G der Anschlußkontakte K im wesentlichen folgende Schichten zu liegen:

1.  elektrische Leitbahnen 2, 4, 6, 8.unter der gesamten Grundfläche G;
2.  Isolierschichten 3, 5, 7 in der Form, daß sie unter halb der Grundfläche G jeweils eine große Öffnung besitzen, innerhalb der Teile der Leitbahnen 4, 6, 8 liegen;

3.  auf der obersten Leitbahn 8 eine sog. Endpassivierungsschicht 9 ebenfalls mit einer großen Öffnung
unterhalb der Grundfläche G.

Die Grundfläche 6 der Anschlußkontakte K ist dabei definiert als horizontale Schnittfläche durch einen Anschlußkontakt K in der Höhe, in der dieser die größte horizontale Ausdehnung auf der Endpassivierungsschicht 9 besitzt.

Bei der Herstellung des bekannten Halbleiterbauelementes
werden die Isolierschichten 3, 5, 7 und die Endpassivierung 9 zunächst ganzflächig aufgebracht und dann in einem
Teilbereich der Grundfläche G der später aufzubringenden
Anschlußkontakte K wieder abgeätzt, so daß an diesen
Stellen zylindrische bzw. quaderförmige Kontaktlöcher entstehen, die teilweise mit den Leitbahnen 4, 6, 8 der Mehrlagenverdrahtung, beispielsweise bestehend aus Aluminium,
Aluminium mit bis zu 4 % Silizium- bzw. Kupferanteil,
Metallfolgen wie Titan, Platin, Gold und/oder elektrisch
leitenden Siliziden, angefüllt sind.

Als oberste Schicht wird dann auf diese Anordnung im Bereich der Grundfläche G der später aufzubringenden Anschlußkontakte K durch Aufdampfen oder Sputtern eine 0,1 bis
2 μm dünne metallische Schichtfolge als Haftschicht H und
Diffusionsbarriere zwischen der Leitbahn 8 und der Endpassierungsschicht 9 einerseits und den künftigen metallischen, höckerartigen Anschlußkontakten K andererseits
aufgebracht. Die Anschlußkontakte K selbst werden ganzflächig beispielsweise durch Bedampfen oder durch galvanische Abscheidung in Verbindung mit Fototechnikschritten
erzeugt und im Falle der ganzflächigen Bedampfung in den
Bereichen außerhalb der zu fertigenden Anschlußkontakte K
wieder abgeätzt.

Unter den Anschlußkontakten K liegt also im wesentlichen eine Schichtfolge von plastisch verformbaren Schichten wie z. B. metallische Leitbahnen, Polyimiden und spröden Schichten, bestehend beispielsweise aus Siliziumnitrid, verschiedene Siliziumoxide. Beim späteren Kontaktiervorgang der Anschlußkontakte K mittels Thermokompression oder Lötbondung besteht nun die große Gefahr, daß in dieser Schichtfolge im Bereich der Leitbahnen 4, 6, 8 und Isolierschichten 3, 5, 7 durch die auftretenden großen Drücke im Bereich unterhalb der Grundfläche G Risse und Brüche entstehen, die die Zuverlässigkeit des Halbleiterbauelementes bis hin zum elektrischen Ausfall beeinträchtigen.

Aufgabe der vorliegenden Erfindung ist es, hier Abhilfe zu schaffen und ein Halbleiterbauelement mit höckerartigen, metallischen Anschlußkontakten und Mehrlagenverdrahtung zu schaffen, bei dem diese Risse und Brüche nicht auftreten können und bei dem demzufolge die elektrische Zuverlässigkeit nicht beeinträchtigt ist.

Diese Aufgabe wird bei einem Halbleiterbauelement der eingangs genannten Art erfindungsgemäß durch die kennzeichnenden Merkmale des Patentanspruchs 1 gelöst.

Das Auftreten von Rissen und Brüchen im Bereich unter den Anschlußkontakten beim Kontaktiervorgang wird durch die erfindungsgemäße Anordnung der Isolierschichten zuverlässig verhindert.

Ausgestaltungen des erfindungsgemäßen Halbleiterbauelementes sind in Unteransprüchen gekennzeichnet.

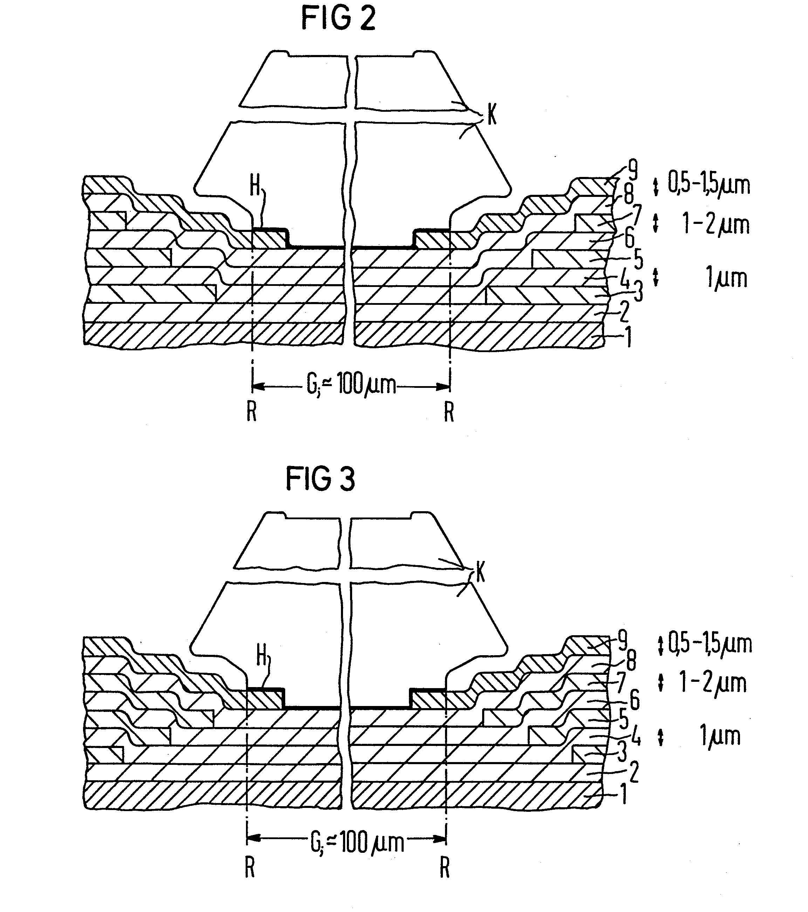

Die Erfindung wird im folgenden anhand der vorteilhaften Ausführungsformen der Figuren 2 bis 4 näher erläutert:

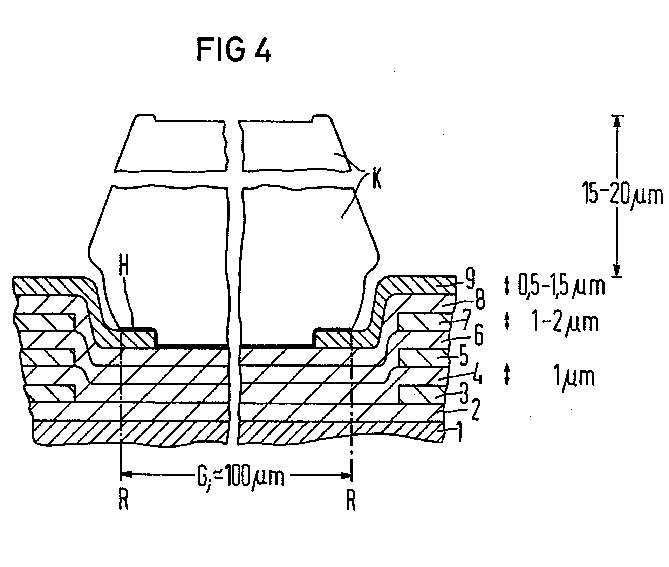

Fig. 4 stellt einen Ausschnitt aus einem erfindungsgemäßen Halbleiterbauelement im Querschnitt dar.
Figuren 2 und 3 stellen ebensolche Ausschnitte aus anderen Weiterbildungen eines erfindungsgemäßen Halbleiterbauelementes dar.

In den Figuren sind gleiche Elemente mit gleichen Bezugszeichen benannt.

Das erfindungsgemäße Halbleiterbauelement nach Fig. 4
enthält im dargestellten Bereich einen höckerartigen,
metallischen Anschlußkontakt K mit der dünnen Haftschicht H
und daran anschließende Leitbahnen 2, 4, 6, 8 und Isolierschichten 3, 5, 7 samt Endpassivierung 9, wobei jeweils
die einzelnen Isolierschichten 3, 5, 7 mindestens 5 μm
von einer gedachten vertikalen Projektionslinie R des
Randes der Grundfläche G des Anschlußkontaktes K auf eine
Grundschicht 1 entfernt enden. Bei der Herstellung des
erfindungsgemäßen Halbleiterbauelementes wird auf diese
Grundschicht 1, beispielsweise eine Oxisschicht, ganzflächig eine Leitbahn 2, beispielsweise bestehend aus
Aluminium, aufgebracht. Auf diese Leitbahn 2 wird zunächst
ganzflächig eine erste Isolierschicht 3 aufgetragen. Diese
kann beispielsweise aus einem Polyimidlack bestehen und
aufgesprüht werden. Im Bereich innerhalb und außerhalb
der Projektionslinie R der nach unten projizierten
Grundfläche G des späteren Anschlußkontaktes K wird diese
Isolierschicht 3 dann wieder abgelöst, beispielsweise
durch Ätzen, so daß diese Isolierschicht 3 mindestens
5 μm von der Projektionslinie R entfernt endet. Jetzt wird,
wiederum ganzflächig, eine zweite Leitbahn 4 aufgebracht,
die natürlich mit dem durch den vorher beschriebenen
Ablösevorgang entstandenen Rand der Isolierschicht 3 eine
Stufe bildet. Auf diese Leitbahn 4 wiederum wird dann
eine Isolierschicht 5 ganzflächig aufgebracht. Dann wird
der Teil der Isolierschicht 5, der über dem abgelösten Bereich der Isolierschicht 3 liegt, abgelöst. Anschließend werden analog zur Leitbahn 4 und der Isolierschicht 5 alternativ weitere Leitbahnen und Isolierschichten aufgetragen, die Isolierschichten entsprechend teilweise wieder abgelöst, so lange, bis alle benötigten Leitbahnen auf das Halbleiterbauelement aufgebracht sind. Abschließend wird dann eine sogenannte Endpassivierung 9 aufgetragen, die unterhalb der Grundfläche G des künftigen Anschlußkontaktes K in einem kleineren Bereich als dem dieser Grundfläche G wieder abgelöst wird. Daraufhin werden, wie eingangs beschrieben, die Haftschicht H und die Anschlußkontakte K aufgebracht. Zu erwähnen ist, daß die Anzahl der Leitbahnen nicht auf die in den Figuren dargestellten vier Lagen beschränkt ist. Ebenfalls beispielhaft sind die in den Figuren dargestellten Maße der Anschlußkontakte, der Leitbahnen und Isolierschichten. Auf diese Art und Weise kommen einerseits alle Leitbahnen 2, 4, 6, 8 unter die Anschlußkontakte K zu liegen und andererseits enden die Isolierschichten 3, 5, 7 jeweils mindestens 5 $\mu$m außerhalb der Projektionslinie R der Grundfläche G der Anschlußkontakte K. Beim späteren Kontaktierungsvorgang wird so die beschriebene, nachteilige Riß- und Bruchbildung in den Schichten unterhalb der Anschlußkontakte K zuverlässig vermieden.

Die erfindungsgemäßen Ausführungsformen nach den Figuren 2 und 3 sind ganz ähnlich gestaltet, nur enden die einzelnen Isolierschichten 3, 5, 7 nicht alle an derselben Stelle, horizontal betrachtet, sondern unterschiedlich weit von der erwähnten Projektionslinie R entfernt, jedoch unterschreitet erfindungsgemäß keine der Isolierschichten 3, 5, 7 das minimale Abstandsmaß von 5 $\mu$m von der Projektionslinie R.

4 Patentansprüche

4 Figuren

Patentansprüche

1. Halbleiterbauelement mit höckerartigen, metallischen Anschlußkontakten und Mehrlagenverdrahtung, dessen verschiedene Leitbahnen eines jeden in Mehrlagentechnik zu verdrahtenden elektrischen Signales bzw. Potentiales, mit Ausnahme eines Teilbereiches unter einer Grundfläche der entsprechend zugehörigen Anschlußkontakte jeweils durch mindestens eine Isolierschicht elektrisch voneinander getrennt sind, wobei besagte Grundfläche definiert ist als horizontale Schnittfläche durch den betreffenden Anschlußkontakt in der Höhe, in der dieser die größte horizontale Ausdehnung auf einer darunter liegenden Endpassivierungsschicht besitzt,
d a d u r c h   g e k e n n z e i c h n e t ,
daß jede der einzelnen Isolierschichten (3, 5, 7) außerhalb von einer gedachten, senkrechten Projektionslinie (R) des Randes der Grundfläche (G) des zugehörigen Anschlußkontaktes (K) endet.

2. Halbleiterbauelement nach Anspruch 1,
d a d u r c h   g e k e n n z e i c h n e t ,
daß der Abstand jeder einzelnen Isolierschicht (3, 5, 7) zu der Projektionslinie (R) mindestens 5 $\mu$m beträgt.

3. Halbleiterbauelement nach Anspruch 2,
d a d u r c h   g e k e n n z e i c h n e t ,
daß alle Isolierschichten (3, 5, 7) gleich weit von der Projektionslinie (R) entfernt enden.

4. Halbleiterbauelement nach Anspruch 2,
d a d u r c h   g e k e n n z e i c h n e t ,
daß die einzelnen Isolierschichten (3, 5, 7) unterschiedlich weit von der Projektionslinie (R) entfernt enden.

FIG 1

K

H

9
8
7
6
5
4
3
2
1

15-20 μm

0,5-1,5 μm

1-2 μm

1 μm

G; ≈ 100 μm

R                R

## FIG 2

9 ↕ 0,5–1,5 μm
8
7 ↕ 1–2 μm
6
5
4 ↕ 1 μm
3
2
1

K

H

$G_i \simeq 100\,\mu m$

R          R

## FIG 3

9 ↕ 0,5–1,5 μm
8
7 ↕ 1–2 μm
6
5
4 ↕ 1 μm
3
2
1

K

H

$G_i \simeq 100\,\mu m$

R          R

FIG 4

K

H

15-20 μm

9
8    0,5-1,5 μm
7
6    1-2 μm
5
4    1 μm
3
2
1

G; ≈ 100 μm

R                    R